# FASCICULE DE BREVET EUROPEEN

(11) **EP 3 764 403 B1**
(45) Date de publication et mention de la délivrance du brevet: **08.03.2023**
(21) Numéro de dépôt: 20184388.5
(22) Date de dépôt: 07.07.2020
(51) Int. Cl.: H01L 31/028, H01L 31/105, H01L 31/18

(54) **FABRICATION D'UN DISPOSITIF PHOTOSENSIBLE À SEMICONDUCTEUR**
HERSTELLUNG EINER FOTOSENSIBLEN VORRICHTUNG MIT HALBLEITER
PRODUCTION OF A PHOTOSENSITIVE DEVICE WITH SEMICONDUCTOR

(30) Priorité: 09.07.2019 FR 1907664
(43) Date de publication de la demande: 13.01.2021
(73) Titulaire: Commissariat à l'Energie Atomique et aux Energies Alternatives, 75015 Paris (FR)
(72) Inventeur: LUDURCZAK, Willy, 38054 Grenoble Cedex 9 (FR); ALIANE, Abdelkader, 38054 Grenoble Cedex 9 (FR); ANDRE, Luc, 38054 Grenoble Cedex 9 (FR); OUVRIER-BUFFET, Jean-Louis, 38054 Grenoble Cedex 9 (FR); WIDIEZ, Julie, 38054 Grenoble Cedex 9 (FR)
(74) Mandataire: Cabinet Beaumont

(56) Documents cités:
- US-A1- 2009 061 557
- US-A1- 2019 140 133
- US-B1- 6 833 195

## Description

### Domaine technique

La présente description concerne de façon générale les dispositifs à semiconducteur, et en particulier un dispositif photosensible à base de germanium.

### Technique antérieure

Des dispositifs photosensibles à base de germanium sont utilisés dans des applications de détection de rayonnements infrarouges ayant par exemple des longueurs d'ondes comprises entre environ 0,9 µm et environ 1,6 µm. Un tel dispositif comprend par exemple une photodiode, c'est-à-dire une diode parcourue par un courant lorsqu'elle reçoit un rayonnement infrarouge.

Les dispositifs photosensibles sont souvent disposés en matrice, par exemple dans un capteur d'images. Chaque dispositif photosensible reçoit le rayonnement en provenance d'une partie d'une scène. La matrice permet alors d'obtenir une image infrarouge de la scène. Chaque pixel de l'image correspond à l'un des dispositifs photosensibles de la matrice.

US 2019/140133 A1 décrit une méthode de fabrication d'un photodétecteur, et US 6833195 B1 décrit une méthode de liaison d'un substrat en germanium à un substrat en silicium.

### Résumé de l'invention

Il existe un besoin d'améliorer les dispositifs connus à base de semiconducteur et leurs procédés de fabrication.

Il existe un besoin de réduire le courant parasite, dit courant d'obscurité, parcourant un dispositif photosensible en l'absence de rayonnement reçu.

Il existe un besoin de réduire les différences de caractéristiques de fonctionnement, telles que le courant d'obscurité et/ou la sensibilité de détection, entre des dispositifs photosensibles prévus pour être identiques, par exemple disposés en matrice.

Il existe un besoin d'améliorer le rendement de fabrication et la fiabilité de dispositifs photosensibles.

Un mode de réalisation pallie tout ou partie des inconvénients des dispositifs connus à base de semiconducteur.

Un mode de réalisation pallie tout ou partie des inconvénients des procédés connus de fabrication de dispositifs à base de semiconducteur.

Un mode de réalisation prévoit un procédé de fabrication d'un dispositif photosensible ayant un courant d'obscurité réduit.

Un mode de réalisation prévoit un procédé de fabrication de dispositifs photosensibles ayant des différences réduites entre leurs caractéristiques de fonctionnement.

Un mode de réalisation prévoit un procédé de fabrication plus fiable que les procédés connus et produisant des dispositifs photosensibles plus fiables que les dispositifs connus.

Un mode de réalisation prévoit un procédé de fabrication d'un dispositif à semiconducteur, comprenant les étapes successives consistant à : a) former, par implantation d'ions hydrogène, une couche enterrée hydrogénée dans un substrat de germanium sous une partie du substrat constituant une couche de germanium ; b) recouvrir le substrat par un premier support ; c) retirer la couche enterrée et la partie du substrat située du côté de la couche enterrée opposé au premier support, en laissant en place, recouvrant le premier support, ladite couche de germanium ; d) former du germanium dopé sur ladite couche de germanium ; e) recouvrir ledit germanium dopé d'un deuxième support ; et f) retirer le premier support, le procédé comprenant en outre, avant l'étape d), une épitaxie de germanium intrinsèque sur ladite couche de germanium.

Selon un mode de réalisation, le premier support et/ou le deuxième support est une tranche de silicium.

Selon un mode de réalisation, le germanium dudit substrat est intrinsèque et monocristallin.

Selon un mode de réalisation, l'étape d'épitaxie de germanium intrinsèque est mise en oeuvre après l'étape c).

Selon un mode de réalisation, à l'étape c), un isolant est situé entre le substrat et le premier support, ledit isolant étant retiré après l'étape e).

Selon un mode de réalisation, à l'étape d), ledit germanium dopé est formé par épitaxie.

Selon un mode de réalisation, ladite couche de germanium est intrinsèque.

Selon un mode de réalisation, ladite couche de germanium est monocristalline et présente de préférence moins de 10 défauts par centimètre carré.

Selon un mode de réalisation, ladite couche de germanium a une épaisseur supérieure ou égale à environ 1 µm.

Selon un mode de réalisation, à l'étape e), une couche isolante est située entre ledit germanium dopé et le deuxième support, ladite couche isolante comprenant de préférence de l'oxyde de silicium.

Selon un mode de réalisation, le procédé comprend, à l'étape e), les étapes consistant à : recouvrir ledit germanium dopé par une première partie de ladite couche isolante ; recouvrir le deuxième support d'une deuxième partie de ladite couche isolante ; et réaliser un collage moléculaire entre les première et deuxième parties de ladite couche isolante.

Selon un mode de réalisation, le procédé comprend, après l'étape f), une épitaxie, sur ladite couche de germanium, de germanium dopé d'un type de conductivité différent de celui du germanium dopé formé à l'étape d).

Selon un mode de réalisation, à l'étape f), le premier support est retiré par gravure ionique et/ou par polissage.

Selon un mode de réalisation, ledit dispositif est une photodiode.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple de dispositif auquel s'appliquent les modes de réalisation décrits ;
la figure 2 est une vue en coupe, partielle et schématique, représentant une étape d'un mode de réalisation d'un procédé de fabrication d'un dispositif à base de semiconducteur ;
la figure 3 est une vue en coupe, partielle et schématique, représentant une autre étape du procédé ;
la figure 4 est une vue en coupe, partielle et schématique, représentant une autre étape du procédé ;
la figure 5 est une vue en coupe, partielle et schématique, représentant une autre étape du procédé ;
la figure 6 est une vue en coupe, partielle et schématique, représentant une autre étape du procédé ;
la figure 7 est une vue en coupe, partielle et schématique, représentant une autre étape du procédé ;
la figure 8 est une vue en coupe, partielle et schématique, représentant une autre étape du procédé ;
la figure 9 est une vue en coupe, partielle et schématique, représentant une autre étape du procédé ;
la figure 10 est une vue en coupe, partielle et schématique, représentant une autre étape du procédé ;
la figure 11 est une vue schématique en coupe représentant une autre étape du procédé ; et
la figure 12 est une vue schématique en coupe représentant une variante de l'étape de la figure 11.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, diverses étapes de formation et/ou retrait de diverses régions ou couches isolantes, semiconductrices ou métalliques, telles que des étapes d'épitaxie, de gravure, de polissage, de traitement thermique, etc., ne sont pas décrites en détail, les modes de réalisation décrits étant compatibles avec les étapes usuelles de formation et/ou retrait de régions ou couches isolantes, semiconductrices ou métalliques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

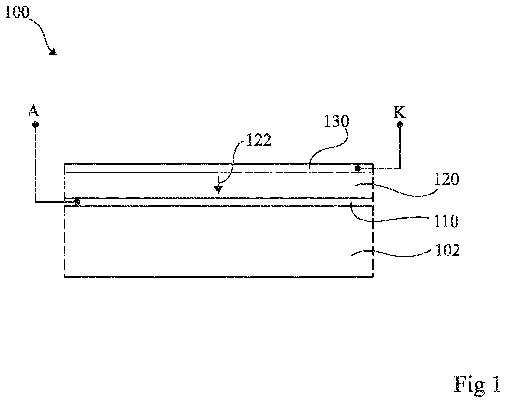

La figure 1 est une vue en coupe, partielle et schématique, d'un exemple de dispositif auquel s'appliquent les modes de réalisation décrits. Plus précisément, dans cet exemple, le dispositif est une photodiode 100 à base de germanium.

A titre d'exemple, la photodiode 100 est située sur un support 102. Le support 102 est typiquement en forme de plaque. Le support 102 est de préférence une portion de tranche semiconductrice, et le support 102 a plus préférentiellement sa face supérieure recouverte d'un isolant (non représenté).

La photodiode 100 est de type PIN, c'est-à-dire qu'elle comprend une région en semiconducteur intrinsèque entre des régions semiconductrices dopées de types opposés. Un semiconducteur est dit ici "intrinsèque" lorsqu'il n'est pas volontairement dopé ou que son niveau de dopage est inférieur à 10¹⁶ atomes par cm³, de préférence inférieur à 10¹⁵ atomes par cm³. La photodiode 100 comprend un empilement, dans l'ordre à partir du support 102, d'une couche 110 de germanium dopé de type P, d'une couche 120 de germanium intrinsèque, et d'une couche 130 de germanium dopé de type N.

Les couches 110 et 130 sont connectées respectivement à des prises de contact A d'anode de la photodiode, et K de cathode de la photodiode. En variante, les couches 110 et 130 ont leurs types de conductivité N et P échangés, et les prises de contact A et K sont échangées.

En fonctionnement, la photodiode est polarisée en inverse. Un rayonnement infrarouge reçu par la photodiode provoque un courant 122 qui circule dans la photodiode de la couche 130 dopée de type N vers la couche 110 dopée de type P à travers la couche intrinsèque 120. Autrement dit, la photodiode PIN 100 est de type vertical, c'est-à-dire que le courant 122 circule de l'une à l'autre des faces principales (supérieure et inférieure) de la couche intrinsèque 120. Un avantage d'une photodiode verticale est que, pour une même sensibilité, elle occupe moins de place qu'une photodiode dans laquelle la région intrinsèque et les régions dopées ne sont pas empilées. Ceci permet par exemple, pour une même sensibilité et une même dimension de capteur d'images, d'augmenter le nombre de pixels de l'image infrarouge obtenue.

Dans certaines applications, la photodiode est polarisée en inverse au cours de la détection de rayonnement. Plus particulièrement, la tension en inverse est suffisante pour obtenir un effet d'avalanche lorsqu'un rayonnement infrarouge est reçu par la photodiode. Avantageusement, il résulte de cet effet d'avalanche une sensibilité accrue par rapport à une photodiode n'utilisant pas l'effet d'avalanche.

Des modes de réalisation décrits dans les figures suivantes prévoient, par rapport aux photodiodes PIN verticales connues, d'augmenter la qualité cristalline de la couche intrinsèque 120. En d'autres mots, dans ces modes de réalisation, la couche intrinsèque 120 est préférentiellement monocristalline et présente, sur au moins une partie de son épaisseur, un nombre particulièrement réduit ou une absence de défauts tels que des dislocations. Ceci permet de réduire le courant d'obscurité de la photodiode.

De plus, lorsque des photodiodes conçues pour être identiques sont fabriquées, on obtient en pratique des écarts entre les caractéristiques de fonctionnement des photodiodes obtenues. Le fait de réduire le nombre de défauts du réseau cristallin de la couche intrinsèque 120, par exemple à une valeur inférieure à 10 défauts par cm², permet de réduire les écarts de caractéristiques de fonctionnement dus aux différences entre les positions et nombres de défauts.

En outre, une réduction du nombre de défauts du réseau cristallin de la couche intrinsèque 120 permet de réduire le risque que la photodiode n'ait pas les caractéristiques de fonctionnement souhaitées, et soit par exemple rejetée au cours d'un test après fabrication. On améliore ainsi le rendement de fabrication des photodiodes. En outre, on réduit le risque que la photodiode se dégrade, et on améliore ainsi la fiabilité de la photodiode.

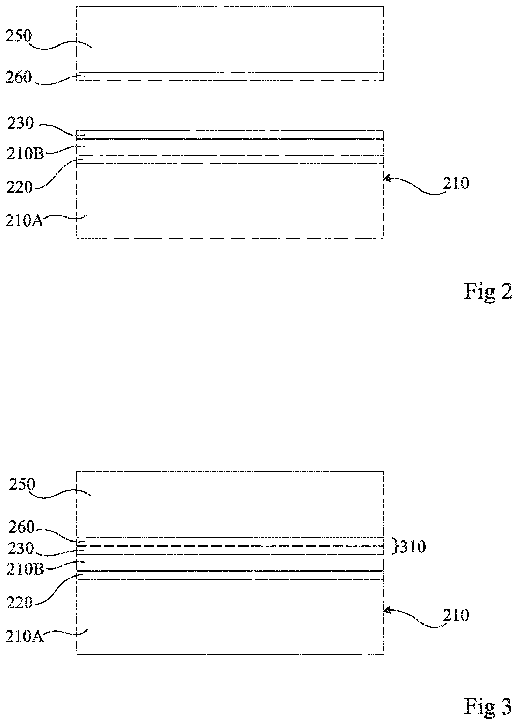

Les figures 2 à 11 sont des vues en coupe, partielles et schématiques, représentant des étapes successives d'un mode de réalisation d'un procédé de fabrication d'un dispositif à base de semiconducteur. Plus précisément, le dispositif est, à titre d'exemple, une photodiode du type décrit en relation avec la figure 1.

Aux étapes des figures 2 à 4, on forme une couche 210B de germanium recouvrant un support 250. Plus précisément, dans l'exemple de ces étapes, la couche 210B est une partie d'un substrat 210 et est formée et mise en place sur le support 250 par un procédé du type connu sous le nom commercial de "Smart Cut".

A l'étape de la figure 2, on prévoit un substrat 210 de germanium. Le substrat 210 a préférentiellement la forme d'une plaque, par exemple le substrat 210 est une tranche de germanium.

Le substrat 210 est de préférence en germanium intrinsèque monocristallin. Plus préférentiellement, le réseau cristallin du substrat 210 ne présente aucun défaut, ou quasiment aucun défaut, c'est-à-dire un nombre de défauts inférieur à 10 par cm², préférentiellement inférieur à 5 par cm². Pour cela, le substrat peut être obtenu par un procédé de Czochralzski.

On implante des ions d'hydrogène à partir de la face supérieure (en figure 2) du substrat 210 de manière à former une couche enterrée hydrogénée 220 dans le substrat 210. La couche enterrée 220 est située sous la couche de germanium 210B. Le reste du substrat 210 correspond à une partie 210A située sous la couche enterrée 220. Il résulte de cette étape que la couche 210B est préférentiellement intrinsèque et monocristalline, et ne présente aucun défaut, ou quasiment aucun défaut. La couche 210B est destinée à constituer tout ou partie de la couche intrinsèque 120 (figure 1) de la future photodiode.

La profondeur de la couche enterrée 220 est liée à l'énergie des ions implantés. Cette profondeur est supérieure à l'épaisseur de la couche de germanium 210B. La couche de germanium 210B a par exemple une épaisseur supérieure à 0,1 µm, plus préférentiellement supérieure à 0,2 µm, encore plus préférentiellement supérieure à 0,5 µm. De préférence, on prévoit l'implantation de sorte que l'épaisseur de la couche de germanium 210B soit la plus grande possible, c'est-à-dire typiquement supérieure ou égale à environ 1 µm. De ce fait, la couche de germanium 210B pourra avantageusement constituer la totalité ou la plus grande partie possible de la couche intrinsèque 120 de la future photodiode. Ceci permettra, dans la future photodiode, de maximiser les avantages susmentionnés liés à la qualité cristalline de la couche intrinsèque 120.

De préférence, on forme sur la couche de germanium 210B une couche 230 électriquement isolante, ou diélectrique. La couche isolante 230 est formée plus préférentiellement après l'implantation des ions d'hydrogène. La couche isolante 230 peut être en oxyde de silicium.

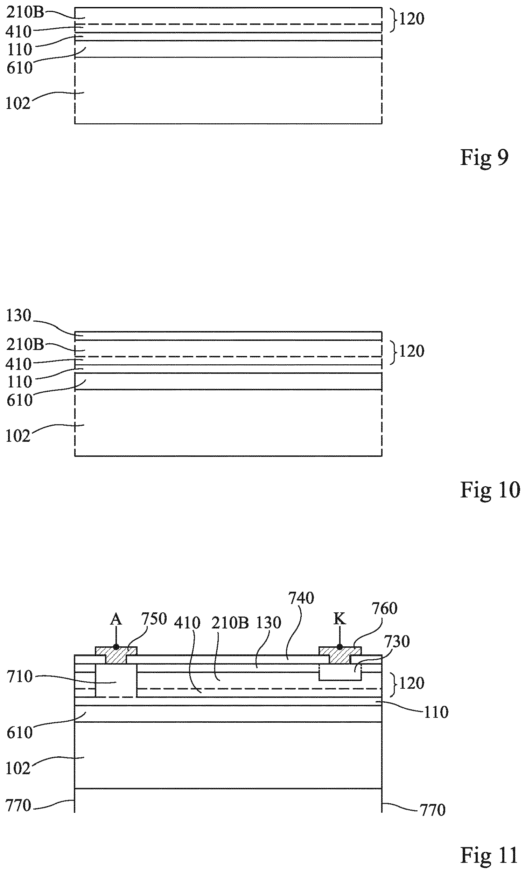

Parallèlement, avant ou après formation de la structure comprenant la partie 210A et les couches 220, 210B et 230, on prévoit le support 250. Le support 250 est typiquement en forme de plaque, avec deux faces principales opposées (inférieure et supérieure en figure 2). Le support 250 est temporaire, c'est-à-dire qu'il est destiné à être retiré à une étape ultérieure (étape de la figure 9). De préférence, le support 250 est une tranche semiconductrice, par exemple en silicium. En variante, tout autre support adapté à un procédé de type connu sous le nom commercial de "Smart Cut" et adapté à être retiré à une étape ultérieure peut être utilisé.

De préférence, on forme une couche électriquement isolante 260 sur la face inférieure du support 250. Plus préférentiellement, le matériau de la couche isolante 260 est le même que celui de la couche isolante 230.

A l'étape de la figure 3, on recouvre la couche de germanium 210B par le support 250. De préférence, pour cela, on assemble les couches isolantes 230 et 260 en mettant en contact leurs faces restées accessibles, c'est-à-dire non recouvertes. De préférence, l'assemblage est de type collage moléculaire, obtenu après polissage des faces destinées à être en contact l'une avec l'autre, mise en contact des couches et application d'une pression. Les couches 230 et 260 constituent alors un isolant 310 entre la couche de germanium 210B et le support 250. Les modes de réalisation décrits ne se limitent pas à un assemblage par collage moléculaire et sont compatibles avec toutes étapes courantes permettant de recouvrir une couche de germanium par un support, par exemple par assemblage et/ou formation du support sur la couche de germanium.

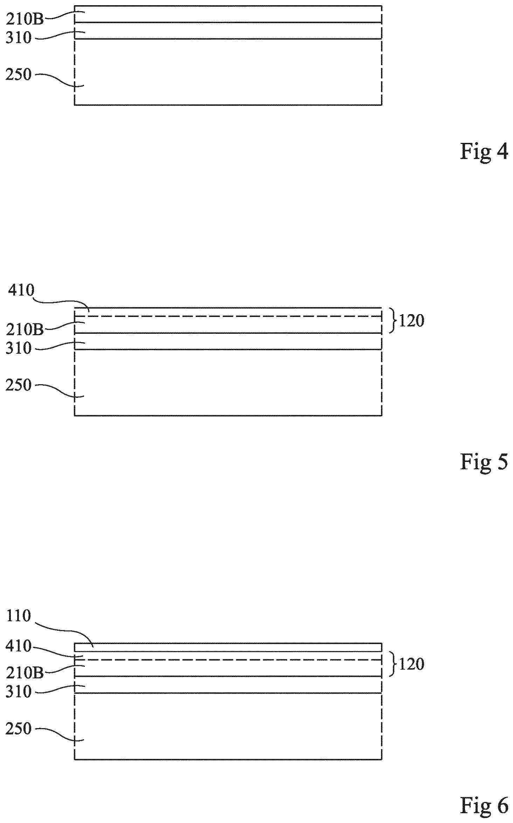

A l'étape de la figure 4, on retire la couche enterrée 220 et la partie 210A du substrat 210, de manière à laisser en place la couche de germanium 210B. La structure de la figure 4 est représentée retournée par rapport à celle de la figure 3, les éléments recouvrant en figure 4 la face supérieure du support 250 étant situés en figure 3 sur la face inférieure du support 250. Pour retirer la couche enterrée 220 et la partie 210A, on procède à un traitement thermique de manière à provoquer la rupture de la couche enterrée 220, puis à un polissage de la face supérieure de la structure représentée en figure 4.

Dans les modes de réalisation décrits, on pourrait remplacer les étapes des figures 2 à 4 par toutes étapes permettant d'obtenir une couche de germanium sur un support, la couche de germanium étant de préférence intrinsèque et monocristalline et encore plus préférentiellement sans ou quasiment sans défaut du réseau cristallin. Le support peut être tout support adapté à être retiré à une étape ultérieure. Par exemple, on remplace les étapes des figures 2 à 4 par la seule prévision d'un substrat tel que le substrat 210, la couche de germanium correspondant à une partie superficielle du substrat, et le reste du substrat correspondant à un support. La structure obtenue correspond à celle de la figure 4, dans laquelle le support est en germanium, et l'isolant 310 est omis. Cependant, par rapport à un tel exemple, la présence de l'isolant 310 facilite le retrait ultérieur du support. On peut aussi obtenir la couche de germanium par exemple par épitaxie sur une couche de germanium dopé destinée à former la couche dopée 110 ou 130 (figure 1). Cependant, par rapport à une épitaxie de germanium, le fait de prévoir que la couche de germanium 210B soit une partie d'un substrat facilite l'obtention de l'état monocristallin sans défaut ou quasiment sans défaut de la couche de germanium 210B.

A l'étape de la figure 5, on fait croître par épitaxie une couche 410 de germanium intrinsèque sur la face de la couche de germanium 210B rendue accessible à l'étape de la figure 4 (face supérieure). Les couches 210B et 410 constituent la couche intrinsèque 120 de la future photodiode. A cette fin, l'épaisseur de la couche épitaxiée 410 est choisie de sorte que la somme des épaisseurs des couches 210B et 410 corresponde à l'épaisseur souhaitée de la couche intrinsèque 120, par exemple cette épaisseur souhaitée est supérieure ou égale à environ 1,5 µm. L'épaisseur de la couche épitaxiée 410 est par exemple comprise entre 20 % et 50 % de celle de la couche de germanium 210B. En variante, l'étape de la figure 5 est omise, et la couche intrinsèque 120 de la future photodiode est constituée de la couche de germanium 210B. Cependant, par rapport à une telle variante, la prévision de la couche 410 permet de faciliter l'obtention de l'épaisseur souhaitée de la couche 120.

Bien que l'étape de la figure 5 ait lieu préférentiellement après l'étape de la figure 4 (retrait de la partie 210A du substrat 210), on peut, en variante, prévoir de former la couche 410 à l'étape de la figure 2 sur la couche de germanium 210B destinée à être laissée en place sur le support 250 à l'étape de la figure 4, avant formation de la couche isolante 230. Après l'étape de la figure 4, la couche 410 est alors située sous la couche de germanium 210B. Cependant, par rapport à une telle variante, le fait que l'étape de la figure 5 ait lieu après celle de la figure 4 permet d'éviter le risque que le budget thermique de l'épitaxie provoque, du fait de la présence de la couche enterrée hydrogénée 220, une séparation entre la partie 210A et la couche de germanium 210B.

A l'étape de la figure 6, on forme du germanium dopé sur la structure obtenue à l'étape de la figure 5, le germanium dopé formant la couche 110 de la future photodiode, telle que décrite en relation avec la figure 1. Autrement dit, le germanium dopé recouvre les couches de germanium 410 et 210B, et est de préférence en contact avec la couche 410. Si l'étape de la figure 5 est omise, le germanium dopé recouvre la couche de germanium 210B, et est de préférence en contact avec la couche de germanium 210B.

De préférence, la couche 110 de germanium dopé est formée par épitaxie. Par rapport à d'autres manières de former la couche 110, ceci permet de contrôler plus précisément l'épaisseur de la couche 110 et son profil de dopage, en particulier le profil de dopage à la jonction entre la couche intrinsèque 120 et le germanium dopé de la couche 110. Ceci permet d'améliorer les caractéristiques de fonctionnement de la photodiode et de limiter les écarts de caractéristiques de fonctionnement entre photodiodes prévues pour être identiques.

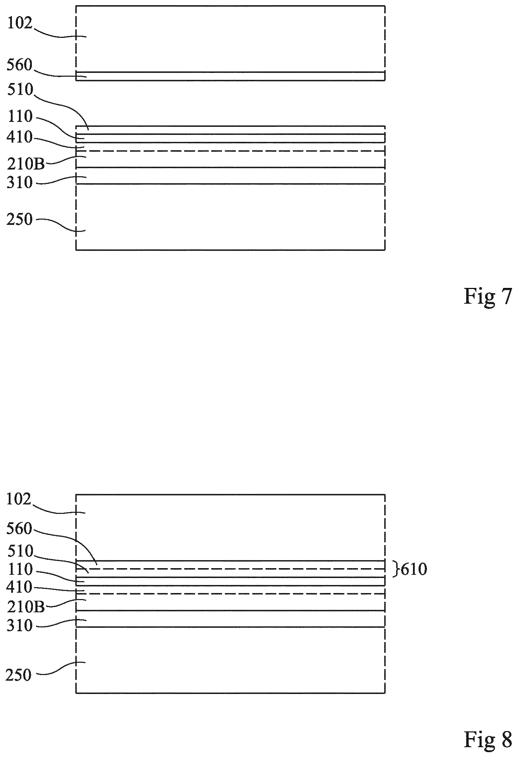

A l'étape de la figure 7, de préférence, on forme, sur la couche 110 de germanium dopé, une couche 510 électriquement isolante, ou diélectrique. La couche isolante 510 peut être en oxyde de silicium.

On prévoit en outre un support tel que le support 102 décrit en relation avec la figure 1, de préférence constitué par une tranche de silicium.

De préférence, on forme une couche électriquement isolante 560 sur la face inférieure du support 102, par exemple en oxyde de silicium. Plus préférentiellement, le matériau de la couche isolante 510 est le même que celui de la couche isolante 560.

A l'étape de la figure 8, la couche 110 de germanium dopé est recouverte par le support 102. De préférence, pour cela, on assemble les couches 510 et 560 en mettant en contact leurs faces restées accessibles. De préférence, l'assemblage est de type collage moléculaire. Les couches 510 et 560 constituent alors une couche isolante 610 entre la couche 410 de germanium dopé et le support 102, les couches 510 et 560 constituant respectivement des première et deuxième parties de la couche 610. En variante, on peut omettre la couche 610. Cependant, le fait de prévoir la couche 610 permet avantageusement d'obtenir une isolation électrique dans la future photodiode entre le support 102 et la couche 110 de germanium dopé. En outre, le fait de prévoir les couches 510 et 560 permet de faciliter le collage moléculaire par rapport à un assemblage dans lequel ces couches seraient omises. Les modes de réalisation décrits ne se limitent pas à un assemblage par collage moléculaire et sont compatibles avec les étapes courantes permettant de recouvrir une couche de germanium dopé par un support, par exemple par assemblage et/ou formation du support sur la couche de germanium dopé.

A l'étape de la figure 9, on retire le support 250. On retire de préférence également l'isolant 310, de manière à rendre accessible la couche de germanium 210B. La structure de la figure 9 est représentée retournée par rapport à celle de la figure 8, les éléments recouvrant en figure 9 la face supérieure du support 102 étant situés en figure 8 sur la face inférieure du support 102. De préférence, le support 250 et l'isolant 310 sont retirés par gravure ionique et/ou par polissage.

Ainsi, dans la structure obtenue à l'étape de la figure 9, la couche 110 de germanium dopé est située entre le support 102 et la couche de germanium 120. Autrement dit, la couche 110 de germanium dopé est enterrée sous la couche supérieure de germanium 120.

On aurait pu penser obtenir une couche de germanium dopé enterrée sous une couche supérieure de germanium par implantation ionique de dopants à travers la couche supérieure de germanium. Par exemple, on aurait pu penser obtenir une couche de germanium dopé enterrée à partir de la couche de germanium 210B telle que celle de la figure 4, en dopant une partie inférieure de la couche 210B à travers une partie supérieure de cette couche. Cependant, la couche supérieure de germanium obtenue aurait eu une épaisseur inférieure à celle de la couche 210B.

En comparaison avec la formation d'une couche enterrée par implantation ionique, les étapes des figures 5 à 9 permettent, à partir d'une structure telle que celle de la figure 4, d'augmenter l'épaisseur de la couche supérieure de germanium. En outre, les étapes des figures 5 à 9 permettent de contrôler plus facilement le profil de dopage de la couche enterrée. De plus, les étapes des figures 5 à 9 permettent d'éviter l'implantation ionique à travers la couche supérieure de germanium, ce qui permet d'éviter tout risque de modifier cette couche au cours de l'implantation. En particulier, dans le cas préféré où la couche 210B est en germanium intrinsèque monocristallin sans défaut ou quasiment sans défaut à l'issue des étapes des figures 2 à 4, la couche 210B reste en germanium monocristallin sans défaut ou quasiment sans défaut à l'issue de l'étape de la figure 9.

Les étapes des figures 2 à 9 permettent ainsi, en particulier, que la couche de germanium 210B obtenue soit en germanium monocristallin sans défaut ou quasiment sans défaut. Plus particulièrement, la couche de germanium intrinsèque 120 de la photodiode est monocristalline sans défaut ou quasiment sans défaut sur au moins une partie de son épaisseur correspondant à la couche 210B. Comme ceci a été mentionné, ceci permet les avantages de réduire le courant d'obscurité, de réduire les différences entre photodiodes prévues pour être identiques, et d'augmenter la fiabilité et le rendement de fabrication. Plus la couche de germanium 210B est épaisse, plus ces avantages sont renforcés.

Les étapes des figures 2 à 9, bien que décrites dans le cas particulier de la fabrication d'une photodiode, peuvent être mises en oeuvre pour fabriquer tout dispositif à base de semiconducteur de type comprenant, sur un support, une région en germanium dopé, telle que la couche 110, surmontée d'une région de germanium de préférence intrinsèque et/ou monocristalline préférentiellement sans ou quasiment sans défaut. En particulier, les avantages mentionnés ci-dessus des étapes 5 à 9 sont conservés pour n'importe quel dispositif de ce type.

A l'étape de la figure 10, on forme une couche 130 dopée de type N. Les types de conductivités P et N des couches de germanium dopé 110 et 130 peuvent être échangés. Ainsi, les couches 110 et 130 ont des types de conductivité opposés. La couche dopée de type N est préférentiellement épitaxiée, ce qui permet de contrôler facilement son épaisseur et son profil de dopage.

A l'étape de la figure 11, on forme par implantation ionique une région dopée de type P 710 s'étendant de la face supérieure de la couche 130 de type N jusqu'à la couche 110 dopée de type P, à travers la couche 130 de type N et la couche intrinsèque 120. On forme par implantation ionique une région dopée de type N 730 séparée de la région P 710 et s'étendant de la face supérieure de la couche 130 de type N, à travers au moins une partie de la couche 130 de type N, préférentiellement jusqu'à un niveau situé dans la couche intrinsèque 120. On forme ensuite une couche isolante 740, par exemple en oxyde de silicium, sur la couche 130 de type N, et, de préférence, en contact avec la couche 130 de type N. La couche isolante 740 présente des ouvertures traversantes sur les régions dopées P 710 et N 730. On remplit ces ouvertures par des régions métalliques 750 et 760 en contact avec les régions dopées respectives P 710 et N 730. Les niveaux de dopage des régions dopées P 710 et N 730 sont préférentiellement plus élevés que ceux des couches respectives P 110 et N 130, en sorte que ces régions forment avec les régions métalliques respectives 750 et 760 des prises de contact respectivement d'anode A et de cathode K de la photodiode.

A titre d'exemple, on a formé simultanément plusieurs photodiodes sur le support 102. On découpe alors le support 102 et les couches 610, 110, 120 et 130 en photodiodes individuelles par des traits de coupe 770.

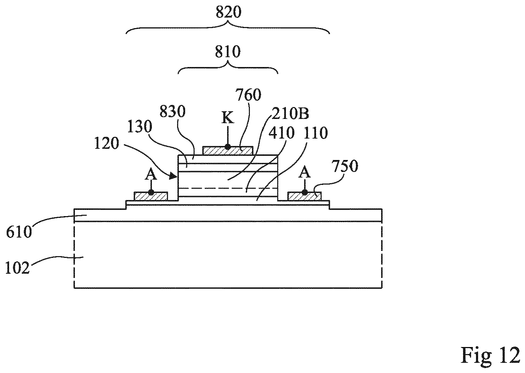

La figure 12 est une vue schématique en coupe représentant une variante de l'étape de la figure 11. Cette variante est compatible avec une diode telle que décrite dans l'article de M. Jutzi et al., intitulé "Ge-on-Si Pin-Photodiodes for Vertical and In-Plane détection of 1300 to 1580 nm Light" et publié dans "ESSCIRC 2004 - Proceedings of the 34th European Solid-State Device Research Conference" en pages 345-347.

On recouvre la structure obtenue à l'étape de la figure 10 d'une couche 830 en contact avec la couche supérieure 130 de type N. La couche 830 est par exemple en silicium dopé de type N.

On retire toutes les parties des couches 830, 130, 120, 110 situées à l'extérieur d'un emplacement 820. Ce retrait est par exemple effectué par une gravure à partir de la face supérieure de la couche 830 jusqu'à au moins la surface supérieure de la couche isolante 610.

On retire toutes les parties restantes des couches 830, 130, et 120 situées à l'extérieur d'un emplacement 810 strictement inclus dans l'emplacement 820. Plus précisément, l'emplacement 820 s'étend de part et d'autre de l'emplacement 810. Ce retrait est par exemple effectué par gravure à partir de la face supérieure de la couche 830 jusqu'à au moins la surface supérieure de la couche 110 de germanium dopé de type P. On a ainsi rendu accessible des parties de la couche 110 de part et d'autre de l'emplacement 820.

On forme ensuite des régions métalliques 750 d'anode A, par exemple en aluminium, sur et en contact avec les parties accessibles de la couche 110. On forme une région métallique 760 de cathode K sur et en contact avec les parties restantes de la couche 830.

Divers modes de réalisation et variantes ont été décrits. L'homme de l'art comprendra que certaines caractéristiques de ces divers modes de réalisation et variantes pourraient être combinées.

Enfin, la mise en oeuvre pratique des modes de réalisation et variantes décrits est à la portée de l'homme du métier à partir des indications fonctionnelles données ci-dessus.

## Revendications

1. Procédé de fabrication d'une photodiode (100) de type PIN, comprenant les étapes successives consistant à :
a) former, par implantation d'ions hydrogène, une couche enterrée hydrogénée (220) dans un substrat (210) de germanium monocristallin intrinsèque sous une partie du substrat constituant une couche de germanium monocristallin intrinsèque (210B) ;
b) recouvrir le substrat (210) par un premier support (250) ;
c) retirer la couche enterrée (220) et la partie (210A) du substrat (210) située du côté de la couche enterrée (220) opposé au premier support (250), en laissant en place, recouvrant le premier support, ladite couche de germanium monocristallin intrinsèque (210B) ;
d) former du germanium dopé (110) sur ladite couche de germanium monocristallin intrinsèque (210B) ;
e) recouvrir ledit germanium dopé d'un deuxième support (102) ; et
f) retirer le premier support (250),
le procédé comprenant en outre, après l'étape a) et avant l'étape b), ou après l'étape c) et avant l'étape d), une épitaxie de germanium intrinsèque (410) sur ladite couche de germanium monocristallin intrinsèque (210B).

2. Procédé selon la revendication 1, dans lequel le premier support (250) et/ou le deuxième support (102) est une tranche de silicium.

3. Procédé selon la revendication 1 ou 2, dans lequel l'étape d'épitaxie de germanium intrinsèque (410) est mise en oeuvre après l'étape c).

4. Procédé selon l'une quelconque des revendications 1 à 3, dans lequel, à l'étape c), un isolant (310) est situé entre le substrat (210) et le premier support (250), ledit isolant (310) étant retiré après l'étape e).

5. Procédé selon l'une quelconque des revendications 1 à 4, dans lequel, à l'étape d), ledit germanium dopé (110) est formé par épitaxie.

6. Procédé selon l'une quelconque des revendications 1 à 5, dans lequel ladite couche de germanium (210B) présente moins de 10 défauts par centimètre carré.

7. Procédé selon l'une quelconque des revendications 1 à 6, dans lequel ladite couche de germanium monocristallin intrinsèque (210B) a une épaisseur supérieure ou égale à environ 1 µm.

8. Procédé selon l'une quelconque des revendications 1 à 7, dans lequel, à l'étape e), une couche isolante (610) est située entre ledit germanium dopé (110) et le deuxième support (102), ladite couche isolante (610) comprenant de préférence de l'oxyde de silicium.

9. Procédé selon l'une quelconque des revendications 1 à 8, comprenant, à l'étape e), les étapes consistant à :
- recouvrir ledit germanium dopé (110) par une première partie (510) de ladite couche isolante (610) ;
- recouvrir le deuxième support (102) d'une deuxième partie (560) de ladite couche isolante (610) ; et
- réaliser un collage moléculaire entre les première (510) et deuxième (560) parties de ladite couche isolante (610).

10. Procédé selon l'une quelconque des revendications 1 à 9, comprenant, après l'étape f), une épitaxie, sur ladite couche de germanium monocristallin intrinsèque (210B), de germanium dopé (130) d'un type de conductivité différent de celui du germanium dopé (110) formé à l'étape d).

11. Procédé selon l'une quelconque des revendications 1 à 10, dans lequel, à l'étape f), le premier support (250) est retiré par gravure ionique et/ou par polissage.

## Patentansprüche

1. Verfahren zur Herstellung einer PIN-Photodiode, das die folgenden aufeinanderfolgenden Schritte umfasst::
a) Bilden, durch Implantation von Wasserstoffionen, einer hydrierten vergrabenen Schicht (220) in einem intrinsischen monokristallinen Germaniumsubstrat (210) unter einem Teil des Substrats, der eine intrinsische monokristalline Germaniumschicht (210B) bildet,;
b) Bedecken des Substrats (210) mit einem ersten Träger (250);
c) Entfernen der vergrabenen Schicht (220) und des Teils (210A) des Substrats (210), der sich auf der Seite der vergrabenen Schicht (220) befindet, die dem ersten Träger (250) gegenüberliegt, wobei die den ersten Träger bedeckende intrinsische monokristalline Germaniumschicht (210B) an Ort und Stelle belassen wird;
d) Bilden von dotiertem Germanium (110) auf der intrinsischen monokristallinen Germaniumschicht (210B);
e) Bedecken des dotierten Germaniums mit einem zweiten Träger (102); und
f) Entfernen des ersten Trägers (250),
wobei das Verfahren ferner nach Schritt a) und vor Schritt b) oder nach Schritt c) und vor Schritt d) eine Epitaxie von intrinsischem Germanium (410) auf der intrinsischen monokristallinen Germaniumschicht (210B) aufweist.

2. Verfahren nach Anspruch 1, wobei der erste Träger (250) und/oder der zweite Träger (102) ein Silizium-Wafer ist.

3. Verfahren nach Anspruch 1 oder 2, wobei der Schritt der Epitaxie von intrinsischem Germanium (410) nach Schritt c) durchgeführt wird.

4. Verfahren nach einem der Ansprüche 1 bis 3, wobei in Schritt c) ein Isolator (310) zwischen dem Substrat (210) und dem ersten Träger (250) angeordnet wird, wobei der Isolator (310) nach Schritt e) entfernt wird.

5. Verfahren nach einem der Ansprüche 1 bis 4, wobei in Schritt d) das dotierte Germanium (110) durch Epitaxie gebildet wird.

6. Verfahren nach einem der Ansprüche 1 bis 5, wobei die Germaniumschicht (210B) monokristallin ist und weniger als 10 Defekte pro Quadratzentimeter aufweist.

7. Verfahren nach einem der Ansprüche 1 bis 6, wobei die intrinsische monokristalline Germaniumschicht (210B) eine Dicke von mehr als oder gleich 1 µm aufweist.

8. Verfahren nach einem der Ansprüche 1 bis 7, wobei in Schritt e) eine Isolierschicht (610) zwischen dem dotierten Germanium (110) und dem zweiten Träger (102) angeordnet wird, wobei die Isolierschicht (610) vorzugsweise Siliziumoxid umfasst.

9. Verfahren nach einem der Ansprüche 1 bis 8, das in Schritt e) die folgenden Schritte aufweist:
- Bedecken des dotierten Germaniums (110) mit einem ersten Abschnitt (510) der Isolierschicht (610);
- Bedecken des zweiten Trägers (102) mit einem zweiten Abschnitt (560) der Isolierschicht (610); und
- Durchführen eines molekularen Bondens zwischen dem ersten (510) und dem zweiten (560) Abschnitt der Isolierschicht (610).

10. Verfahren nach einem der Ansprüche 1 bis 9, aufweisend nach Schritt f) eine Epitaxie auf der Germaniumschicht (210B) von dotiertem intrinsischem monokristallinem Germanium (130) eines Leitfähigkeitstyps, der sich von dem des in Schritt d) gebildeten dotierten Germaniums (110) unterscheidet.

11. Verfahren nach einem der Ansprüche 1 bis 10, wobei in Schritt f) der erste Träger (250) durch lonenätzen und/oder Polieren entfernt wird.

## Claims

1. A method of manufacturing a PIN photodiode, comprising the successive steps of:
a) forming, by implantation of hydrogen ions, a hydrogenated buried layer (220) in an intrinsic monocrystalline germanium substrate (210) under a portion of the substrate forming an intrinsic monocrystalline germanium layer (210B);
b) covering the substrate (210) with a first support (250) ;
c) removing the buried layer (220) and the portion (210A) of the substrate (210) located on the side of the buried layer (220) opposite to the first support (250), while leaving in place, covering the first support, said intrinsic monocrystalline germanium layer (210B);
d) forming doped germanium (110) on said intrinsic monocrystalline germanium layer (210B);
e) covering said doped germanium with a second support (102); and
f) removing the first support (250),
the method further comprising, after step a) and before step b), or after step c) and before step d), an epitaxy of intrinsic germanium (410) on said intrinsic monocrystalline germanium layer (210B).

2. The method according to claim 1, wherein the first support (250) and/or the second support (102) is a silicon wafer.

3. The method according to claim 1 or 2, wherein the step of epitaxy of intrinsic germanium (410) is implemented after step c).

4. The method according to any of claims 1 to 3, wherein, at step c), an insulator (310) is located between the substrate (210) and the first support (250), said insulator (310) being removed after step e).

5. The method according to any of claims 1 to 4, wherein, at step d), said doped germanium (110) is formed by epitaxy.

6. The method according to any of claims 1 to 5, wherein said germanium layer (210B) is monocrystalline has less than 10 defects per square centimeter.

7. The method according to any of claims 1 to 6, wherein said intrinsic monocrystalline germanium layer (210B) has a thickness greater than or equal to 1 pm.

8. The method according to any of claims 1 to 7, wherein, at step e), an insulating layer (610) is located between said doped germanium (110) and the second support (102), said insulating layer (610) preferably comprising silicon oxide.

9. The method according to any of claims 1 to 8, comprising, at step e), the steps of:
- covering said doped germanium (110) with a first portion (510) of said insulating layer (610);
- covering the second support (102) with a second portion (560) of said insulating layer (610); and
- performing a molecular bonding between the first (510) and second (560) portions of said insulating layer (610).

10. The method according to any of claims 1 to 9, comprising, after step f), an epitaxy, on said germanium layer (210B), of doped intrinsic monocrystalline germanium (130) of a conductivity type different from that of the doped germanium (110) formed at step d).

11. The method according to any of claims 1 to 10, wherein, at step f), the first support (250) is removed by ion etching and/or by polishing.
